# EUROPEAN PATENT APPLICATION

(11) **EP 4 651 695 A1**
(43) Date of publication of application: **19.11.2025**
(21) Application number: 23916072.4
(22) Date of filing: 22.06.2023
(51) Int. Cl.: H10N 30/076, C23C 14/08, C23C 14/58, C30B 29/32, C30B 33/02, H01L 21/314, H10N 30/853, H10N 30/87

(54) **METHOD FOR MANUFACTURING PIEZOELECTRIC FILM SUBSTRATE AND PIEZOELECTRIC FILM SUBSTRATE**

(30) Priority: 10.01.2023 JP 2023001901
(71) Applicant: Sumitomo Precision Products Co., Ltd., Hyogo 660-0891 (JP)
(72) Inventor: KIUCHI, Mario, Amagasaki-shi, Hyogo 660-0891 (JP); KATAYAMA, Nobuhide, Amagasaki-shi, Hyogo 660-0891 (JP)
(74) Representative: Viering, Jentschura & Partner mbB Patent- und Rechtsanwälte
(86) International application number: PCT/JP2023/023109
(87) International publication number: WO 2024/150452

(57) **Abstract**

A method of manufacturing the piezoelectric film substrate (100) according to this invention includes forming a lower electrode (2) on a substrate (1); and forming a piezoelectric film (3) on the lower electrode, wherein the forming the piezoelectric film includes forming, on the lower electrode, a first layer (33) serving as a seed layer at a first temperature (Te1) at which the first layer crystallizes and epitaxially grows, and forming, on the first layer, a second layer (34) including a part formed at a second temperature (Te2) that is lower than the first temperature and at which the part crystallizes.

## Description

### Technical Field

The present invention relates to a piezoelectric-film-substrate-manufacturing method and a piezoelectric film substrate, in particular to a method manufacturing a piezoelectric film substrate and a piezoelectric film substrate including a piezoelectric film formed on a lower electrode.

### Background Art

Methods manufacturing ferroelectric capacitors including ferroelectric materials formed on lower electrodes are known in the art. Such a method manufacturing a ferroelectric capacitor is disclosed in Japanese Patent Laid-Open Publication No. JP 2010-171456, for example.

The above Japanese Patent Laid-Open Publication No. JP 2010-171456 discloses a method manufacturing a ferroelectric capacitor including a ferroelectric material formed on a lower electrode and an upper electrode formed on the ferroelectric material. In this manufacturing method, a first ferroelectric layer is formed on the lower electrode at a temperature not lower than the crystallization temperature, and a second ferroelectric layer is formed on the first ferroelectric layer at a temperature lower than the crystallization temperature. In this manufacturing method, since the second ferroelectric layer has not a crystal structure but an amorphous structure, generation of defects at the interface between the upper electrode and the second ferroelectric layer is reduced. As a result, in a case where the ferroelectric capacitor is applied to nonvolatile memories, the structure exhibits improved fatigue resistance, meaning reduced degradation in polarization caused by repeated polarization reversal of the ferroelectric material.

### Prior Art

### Patent Document

Patent Document 1: Japanese Patent Laid-Open Publication No. JP 2010-171456

### Summary of the Invention

### Problems to be Solved by the Invention

Although the above-mentioned Patent Publication No. 2010-171456 states the method manufacturing ferroelectric material applied to memories, it does not state any method manufacturing a piezoelectric film applied to actuators or sensors. In a case where the piezoelectric film applied to actuators or sensors, high actuator or sensor properties are required for the piezoelectric film. In addition, in order to achieve high actuator or sensor properties of the piezoelectric film, high crystallinity is required for the piezoelectric dissimilar to a case in which the material is applied to memories. Also, in order to achieve high crystallinity of the piezoelectric film, the piezoelectric film is required to be formed at a high temperature. However, when the piezoelectric film is formed at a high temperature, the difference between the thermal expansion coefficients of the piezoelectric film and the lower electrode increases the film stress, which causes disadvantages. For these reasons, it is desirable to form a piezoelectric film having high crystallinity while suppressing an increase in film stress caused by the difference between the thermal expansion coefficients of the piezoelectric film and the lower electrode.

The present invention is intended to solve the above problem, and one object of the present invention is to provide a piezoelectric-film-substrate-manufacturing method and a piezoelectric film substrate capable of forming a piezoelectric film having high crystallinity while suppressing an increase in film stress caused by the difference between the thermal expansion coefficients of the piezoelectric film and a lower electrode.

### Means for Solving the Problems

In order to attain the aforementioned object, the present inventor diligently studied a piezoelectric-film-substrate-manufacturing method and a piezoelectric film substrate; as a result, found that forming a piezoelectric film including forming, on a lower electrode, a first layer serving as a seed layer at a first temperature at which the first layer crystallizes and epitaxially grows, and forming, on the first layer, a second layer including a part formed at a second temperature that is lower than the first temperature and at which the part crystallizes can provide a piezoelectric film having high crystallinity while suppressing an increase in film stress caused by the difference between thermal expansion coefficients of the piezoelectric film and the lower electrode; and thus completed the present invention. That is, a piezoelectric-film-substrate-manufacturing method according to a first aspect of this invention includes forming a lower electrode on a substrate; and forming a piezoelectric film on the lower electrode, wherein the forming the piezoelectric film includes forming, on the lower electrode, a first layer serving as a seed layer at a first temperature at which the first layer crystallizes and epitaxially grows, and forming, on the first layer, a second layer including a part formed at a second temperature that is lower than the first temperature and at which the part crystallizes.

In the piezoelectric-film-substrate-manufacturing method according to according to the first aspect of the present invention, as discussed above, the forming the piezoelectric film includes forming, on the lower electrode, a first layer serving as a seed layer at a first temperature at which the first layer crystallizes and epitaxially grows, and forming, on the first layer, a second layer including a part formed at a second temperature that is lower than the first temperature and at which the part crystallizes. Accordingly, the second layer, having a certain high degree of crystallinity, can be formed under the influence of the first layer (seed layer) having high crystallinity. Consequently, the piezoelectric film having high crystallinity can be provided. In addition, an increase in film stress caused by the difference between thermal expansion coefficients of the piezoelectric film and the lower electrode can be suppressed by forming, on the first layer, the second layer including the part formed at the second temperature lower than the first temperature as compared with a case where the entire piezoelectric film is formed at a higher temperature. Therefore, it is possible to form the piezoelectric film having high crystallinity while being able to suppress an increase in film stress caused by the difference between the thermal expansion coefficients of the piezoelectric film and the lower electrode.

In the piezoelectric-film-substrate-manufacturing method according to the aforementioned first aspect, it is preferable that the forming the second layer includes forming the second layer thicker than the first layer. According to this configuration, since the thickness of the second layer can be larger than the thickness of the first layer formed at the first temperature, it is possible to easily suppress an increase in film stress caused by the difference between thermal expansion coefficients of the piezoelectric film and the lower electrode,

In the piezoelectric-film-substrate-manufacturing method according to the aforementioned first aspect, it is preferable that the first temperature is not lower than 560°C and not higher than 700°C; and that the second temperature is not lower than 500°C and lower than 560°C. According to this configuration, the first layer can be easily crystallized and epitaxially grown by setting the first temperature to not lower than 560°C and not higher than 700°C. In addition, the increase in film stress caused by the difference between thermal expansion coefficients of the piezoelectric film and the lower electrode can be suppressed while the second layer is crystallized by setting the second temperature to not lower than 500°C and lower than 560°C.

In the piezoelectric-film-substrate-manufacturing method according to the aforementioned first aspect, it is preferable that the forming the second layer includes forming the second layer during continuous temperature change from the first temperature to the second temperature after the first layer is formed. According to this configuration, since the second layer can easily inherit the crystallinity of the first layer, the second layer can be formed with higher crystallinity. Also, dissimilar to a case where the second layer is not formed during the temperature change from the first temperature to the second temperature, the second layer can be formed also during the temperature change from the first temperature to the second temperature, it is possible to improve the productivity.

In this configuration, it is preferable that a thickness of the first layer is not smaller than 1% and smaller than 50% of a total thickness of the piezoelectric film. According to this configuration, the thickness of the first layer set to not smaller than 1% of the total thickness of the piezoelectric film allows the first layer to easily serve as the seed layer. In addition, by setting the thickness of the first layer to smaller than 50% of the total thickness of the piezoelectric film, the thickness of the first layer can be prevented from becoming excessively larger, thereby suppressing the increase in film stress caused by the difference between the thermal expansion coefficients of the piezoelectric film and the lower electrode.

In the piezoelectric-film-substrate-manufacturing method according to the aforementioned first aspect, it is preferable that a single-crystalline first region including the first layer and a part of the second layer that inherits a crystal orientation characteristic of the first layer, and a polycrystalline second region including a remaining part of the second layer are sequentially formed by sequentially performing the forming the first layer and the forming the second layer. According to this configuration, the piezoelectric film having high crystallinity while suppressing the increase in film stress caused by the difference between the thermal expansion coefficients of the piezoelectric film and the lower electrode can be formed by sequentially forming the first region and the second region.

In order to attain the aforementioned object, a piezoelectric film substrate according to a second aspect of the present invention includes a substrate; a lower electrode formed on the substrate; and a piezoelectric film formed on the lower electrode, wherein the piezoelectric film includes a single-crystalline first region arranged adjacent to the lower electrode and a polycrystalline second region arranged adjacent to the first region.

In the piezoelectric film substrate according to the second aspect of the present invention, as discussed above, the piezoelectric film includes the first region, which is arranged adjacent to the lower electrode and includes large single-crystal parts, and the polycrystalline second region, which is arranged adjacent to the first region. Accordingly, as a result of formation of the first layer, which crystallizes and epitaxially grows at a first temperature serving as a seed layer, on the lower electrode, and the second layer, which crystallizes and includes a part formed at the second temperature lower than the first temperature, on the first layer, the piezoelectric film substrate including the first region and the second region can be provided. Therefore, similar to the piezoelectric-film-substrate-manufacturing method according to the aforementioned first aspect, it is possible to provide the piezoelectric film substrate capable of forming the piezoelectric film having high crystallinity while suppressing the increase in film stress caused by the difference between the thermal expansion coefficients of the piezoelectric film and the lower electrode.

### Effect of the Invention

According to the present invention, as discussed above, it is possible to form a piezoelectric film having high crystallinity while being able to suppress an increase in film stress caused by the difference between thermal expansion coefficients of the piezoelectric film and a lower electrode.

### Brief Description of the Drawings

FIG. 1 is a cross-sectional view showing a piezoelectric film substrate according to the one embodiment.
FIG. 2 is a schematic cross-sectional view illustrating a first region and a second region of a piezoelectric film according to the one embodiment.
FIG. 3 is a cross-sectional view showing the substrate in a manufacturing process according to the one embodiment.
FIG. 4 is a cross-sectional view showing the substrate with a lower electrode formed in a manufacturing process according to the one embodiment.
FIG. 5 is a cross-sectional view showing the substrate with a first layer film of the piezoelectric film formed in a manufacturing process according to the one embodiment.
FIG. 6 is a cross-sectional view showing the substrate with a second layer film of the piezoelectric film formed in a manufacturing process according to the one embodiment.
FIG. 7 is a graph showing a temperature profile in formation of the first layer and the second layer of the piezoelectric film in manufacturing processes according to the one embodiment.
FIG. 8 is a cross-sectional view showing the substrate with an upper electrode formed in a manufacturing process according to the one embodiment. Modes for Carrying Out the Invention

The following description will describe embodiments according to the present invention with reference to the drawings.

### (Configuration of Piezoelectric Film Substrate)

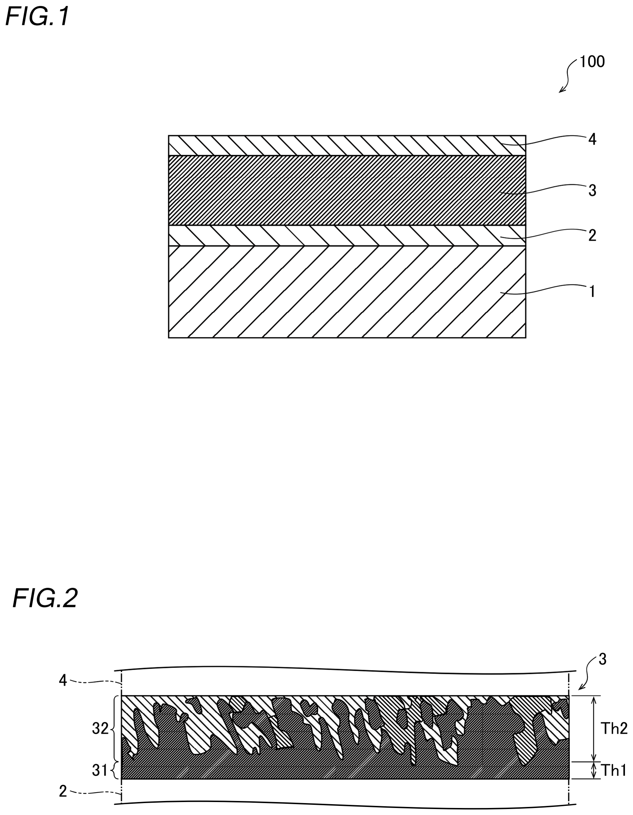

A configuration of a piezoelectric film substrate 100 according to one embodiment of the present invention is described with reference to FIGS. 1 to 2.

The piezoelectric film substrate 100 is a piezoelectric film substrate to be divided into a plurality of pieces as devices. Each of the plurality of pieces becomes the device. For example, the device is a MEMS (Micro Electro Mechanical Systems) device. Also, the MEMS device is used as a sensor or actuator, for example.

As shown in FIG. 1, the piezoelectric film substrate 100 includes a substrate 1, a lower electrode 2, a piezoelectric film 3, and an upper electrode 4.

The substrate 1 is a silicon substrate. The lower electrode 2 is formed on the substrate 1. Specifically, the lower electrode 2 is formed as a single crystal by epitaxial growth on the single-crystal substrate 1. Also, the lower electrode 2 is a multilayer electrode that includes an electrically insulating layer, an electrode layer, and a buffer layer. The insulating layer, the electrode layer and the buffer layer are arranged in this order from the substrate 1 side. Also, the electrically insulating layer is formed of a material such as zirconium oxide (ZrO2) or yttria stabilized zirconia (YSZ). The electrode layer is formed of a material such as platinum (Pt), iridium (Ir), cerium oxide (CeO₂), high-temperature copper oxide superconductor (LSCO), lanthanum (La) or strontium (Sr). The buffer layer is formed of a material such as strontium ruthenate (SrRuO₃) or lanthanum nickelate (LaNiO₃). Here, the material of each layer in the lower electrode 2 is not limited to a specific material. Also, the lower electrode 2 may be a single-layer electrode.

The piezoelectric film 3 is formed on the lower electrode 2. The piezoelectric film 3 is formed of lead zirconate titanate (PZT), which exhibits ferroelectricity. Also, a thermal expansion coefficient of the piezoelectric film 3 is different from a thermal expansion coefficient of the lower electrode 2.

FIG. 2 schematically illustrates an analysis result of the piezoelectric film 3 using a crystal orientation analysis technique such as backscatter electron diffraction (EBSD). In FIG. 2, hatched parts, which differ from each other, represent different crystal orientations in the piezoelectric film 3.

Here, in this embodiment, as shown in FIG. 2, the piezoelectric film 3 includes a single-crystalline first region 31 arranged adjacent to the lower electrode 2 and a polycrystalline second region 32 arranged adjacent to the first region 31. The first region 31 is a lower region of the piezoelectric film 3 that is substantially a single crystal and in which the crystal orientation is substantially fixed. The second region 32 is a region located on the upper side relative to the first region 31 in the piezoelectric film 3, and is a region that is polycrystalline and in which a plurality of crystal orientations are mixed and distributed. The first region 31 and the second region 32 are formed by forming the piezoelectric film 3 by a manufacturing method described later. A thickness Th2 of the second region 32 is greater than a thickness Th1 of the first region 31. The boundary between the first region 31 and the second region 32 is not positioned at a fixed position in a thickness direction, and the thicknesses of the first region 31 and the second region 32 vary depending on the measurement position. However, the thicknesses Th1 and Th2 are obtained by averaging the thicknesses of the first region 31 and the second region 32 at each measurement position. The thickness Th1 refers to an average thickness of the first region 31. Also, the thickness Th2 refers to an average thickness of the second region 32.

As shown in FIG. 1, the upper electrode 4 is formed on the piezoelectric film 3. The upper electrode 4 may be crystalline or amorphous. Also, the upper electrode 4 is a multilayer electrode that includes an electrode layer and a buffer layer. The buffer layer and the electrode layer are arranged in this order from the piezoelectric film 3 side. Also, the electrode layer is formed of a material such as titanium (Ti), gold (Au), platinum (Pt) or iridium dioxide (IrO₂). The buffer layer is formed of a material such as strontium ruthenate (SrRuO₃) or lanthanum nickelate (LaNiO₃). Here, the material of each layer in the upper electrode 4 is not limited to a specific material. Also, the upper electrode 4 may be a single-layer electrode.

### (Piezoelectric-Film-Substrate-Manufacturing Method)

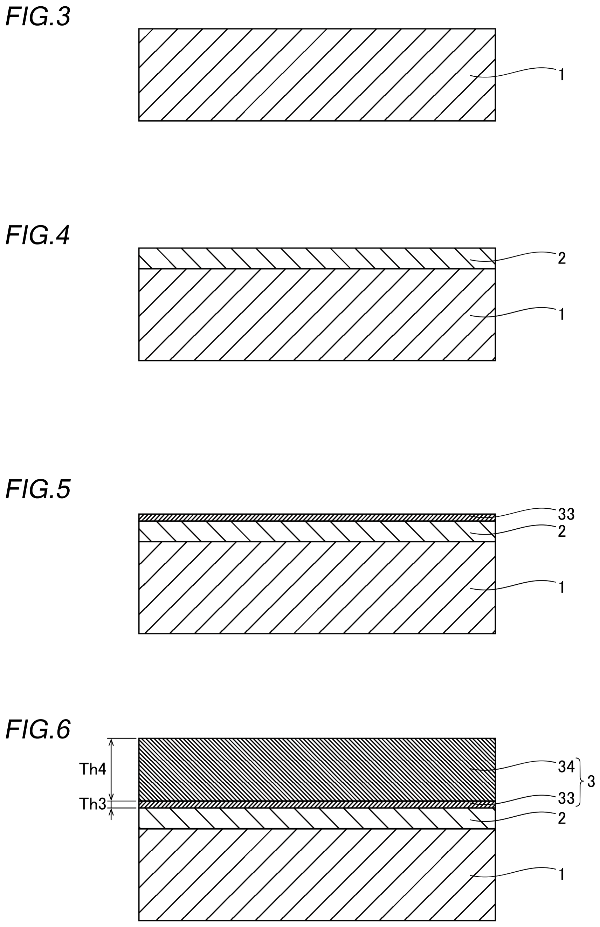

The method manufacturing the piezoelectric film substrate 100 is now described with reference to FIGS. 3 to 8. The method manufacturing the piezoelectric film substrate 100 is a method manufacturing a piezoelectric film substrate to be divided into a plurality of pieces as devices. The method manufacturing the piezoelectric film substrate 100 includes a step of preparing the substrate 1, a step of forming the lower electrode 2 on the substrate 1, a step of forming the piezoelectric film 3 on the lower electrode 2, and a step of forming the upper electrode 4 on the piezoelectric film 3.

As shown in FIG. 3, in the step of preparing the substrate 1, the silicon substrate is prepared. As shown in FIG. 4, in the step of forming the lower electrode 2 on the substrate 1, a multilayer film including an electrically insulating layer, an electrode layer and a buffer layer, or a single-layer film is stacked on the substrate 1 by sputtering. In this step, the substrate 1 is heated to form the lower electrode 2 on the single-crystal substrate 1 at a temperature at which the lower electrode crystallizes and epitaxially grows. Accordingly, the single-crystal lower electrode 2 is formed, inheriting the crystal orientation characteristics of the single-crystal substrate 1.

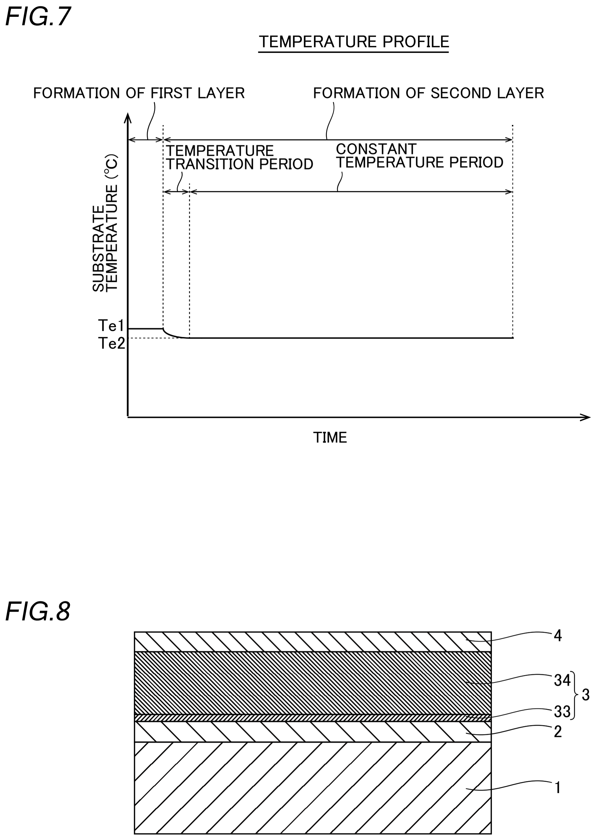

Here, in this embodiment, as shown in FIGS. 5 and 6, the step of forming the piezoelectric film 3 on the lower electrode 2 includes a step of forming, on the lower electrode 2, a first layer 33 serving as a seed layer at a first temperature Te1 (see FIG. 7) at which the first layer crystallizes and epitaxially grows, and a step of forming, on the first layer 33, a second layer 34 including a part formed at a second temperature Te2 (see FIG. 7) that is lower than the first temperature Te1 and at which the part crystallizes. In the step of forming the first layer 33, a piezoelectric material exhibiting ferroelectricity is stacked on the lower electrode 2 by sputtering. Accordingly, the first layer 33 is formed. In the step of forming the second layer 34, the same piezoelectric material as the first layer 33 is stacked on the first layer 33 by sputtering. Accordingly, the second layer 34 is formed. It should be noted that, although the boundary between the first layer 33 and the second layer 34 is shown visibly for illustrative purposes in FIG. 6 (and FIG. 8), in reality, little or no boundary exists between the first layer 33 and the second layer 34, as they are formed from the same material.

Also, in this embodiment, in the step of forming the second layer 34, the second layer 34 is formed to be thicker than the first layer 33. In other words, a thickness Th4 of the second layer 34 is greater than a thickness Th3 of the first layer 33. The thickness Th3 of the first layer 33 is preferably not smaller than approximately 1% and smaller than approximately 50% of the total thickness of the piezoelectric film 3. Also, the thickness Th4 of the second layer 34 is preferably not smaller than approximately 50% of the total thickness of the piezoelectric film 3. For example, in a case where the total thickness of the piezoelectric film 3 is approximately 5 µm, the thickness Th3 of the first layer 33 is preferably not smaller than approximately 0.05 µm and smaller than approximately 2.5 µm, and the thickness Th4 of the second layer 34 is preferably not smaller than approximately 2.5 µm. Also, the total thickness of the piezoelectric film 3 is preferably not smaller than approximately 1 µm and not greater than approximately 5 µm.

FIG. 7 is a graph showing a temperature profile in formation of the first layer 33 and the second layer 34. In the graph shown in FIG. 7, the vertical axis indicates the temperature of the substrate 1, while the horizontal axis indicates time. As shown in FIG. 7, in the step of forming the first layer 33, the substrate 1 is heated to form the first layer 33 at the first temperature Te1. In the step of forming the second layer 34, the substrate 1 is heated to form the second layer 34 mainly at the second temperature Te2. It is preferable that the first temperature Te1 is relatively high among temperatures at which the first layer 33 crystallizes from the viewpoint of epitaxial growth of the first layer 33, and is not lower than approximately 560°C and not higher than approximately 700°C. Also, it is preferable that the second temperature Te2 is relatively low among temperatures at which second layer 34 crystallizes from the viewpoint of suppression of an increase in film stress caused by the difference between thermal expansion coefficients of the lower electrode 2 and the piezoelectric film 3, and is not lower than approximately 500°C and lower than approximately 560°C. Although the first temperature Te1 and the second temperature Te2 are not limited to specific values, the first temperature Te1 can be approximately 600°C and the second temperature Te2 can be approximately 540°C, for example.

Also, in this embodiment, in the forming the second layer 34, the second layer 34 is formed during continuous temperature change from the first temperature Te1 to the second temperature Te2 after the first layer 33 is formed. In other words, the second layer 34 is formed both during the temperature change from the first temperature Te1 to the second temperature Te2 and after the second temperature Te2 is reached. The second layer 34 includes a part that is formed during the temperature change from the first temperature Te1 to the second temperature Te2, and a part that is formed after the second temperature Te2 is reached. Also, the step of forming the first layer 33 and the step of forming the second layer 34 are performed consecutively, with no time interval between them. In other words, sputtering is performed continuously, without interruption, during the step of forming the first layer 33 and the step of forming the second layer 34. The first layer 33 and the second layer 34 may be formed by PLD (pulsed laser deposition) or CVD (chemical vapor deposition), rather than by sputtering.

Also, in the step of forming the first layer 33, the single-crystal first layer 33, which inherits the crystal orientation characteristics of the single-crystal lower electrode 2, is formed by depositing its material at the first temperature Te1 at which the first layer crystallizes and epitaxially grows. Also, in the step of forming the second layer 34, a part of the single-crystalline second layer 34 that inherits the crystal orientation characteristics of the first layer 33 under the influence of the single-crystal first layer 33 serving as the seed layer is first formed by depositing its material during the temperature change from the first temperature Te1 to the second temperature Te2 and at the second temperature Te2. Subsequently, the influence of the single-crystal first layer 33 decreases and is nearly lost, resulting in the formation of a polycrystalline part of the second layer 34. In other words, in this embodiment, the single-crystalline first region 31 (see FIG. 2) including the first layer 33 and a part of the second layer 34 that inherits the crystal orientation characteristics of the first layer 33, and the polycrystalline second region 32 (see FIG. 2) including the remaining part of the second layer 34 are sequentially formed by sequentially performing the step of forming the first layer 33 and the step of the second layer 34. Here, the thickness Th1 of the first region 31 is greater than the thickness Th3 of the first layer 33. Also, the thickness Th2 of the second region 32 is smaller than the thickness Th4 of the second layer 34.

As described above, in the step of forming the piezoelectric film 3, the piezoelectric film 3 including the first region 31 and the second region 32 is formed. In the step of forming the piezoelectric film 3, the piezoelectric film 3 having a perovskite structure is formed. Here, the A site of the perovskite structure is not doped with elements such as lanthanum (La), strontium (Sr), or calcium (Ca).

As shown in FIG. 8, in the step of forming the upper electrode 4 on the piezoelectric film 3, a multilayer film including an electrode layer and a buffer layer, or a single-layer film is stacked on the piezoelectric film 3 by sputtering. In this step, the substrate 1 is not heated, and the upper electrode 4 is thus formed on the piezoelectric film 3 at room temperature. According to these steps, the piezoelectric film substrate 100 is manufactured.

Subsequently, if processing is applied to the substrate to form device shapes, photolithography is applied to the substrate to pattern the lower electrode 2, the piezoelectric film 3 and the upper electrode 4 into the device shapes, for example. In the case of photolithography, the processing is applied to the substrate to pattern the lower electrode 2, the piezoelectric film 3 and the upper electrode 4 into the device shapes by removing unnecessary portions and preserving necessary portions by using wet etching with an etching solution or dry etching using an etching gas. In addition, when the piezoelectric film substrate 100 is divided into the pieces P for the devices, the piezoelectric film substrate 100 is cut into the pieces for the devices by using a blade, for example.

### (Advantages of the Embodiment)

In this embodiment, the following advantages are obtained.

In this embodiment, as described above, a method of manufacturing the piezoelectric film substrate 100 includes a step of forming a lower electrode 2 on a substrate 1; and a step of forming a piezoelectric film 3 on the lower electrode 2, wherein the step of forming the piezoelectric film 3 includes a step of forming, on the lower electrode 2, a first layer 33 serving as a seed layer at a first temperature Te1 at which the first layer crystallizes and epitaxially grows, and a step of forming, on the first layer 33, a second layer 34 including a part formed at a second temperature Te2 that is lower than the first temperature Te1 and at which the part crystallizes.

According to the aforementioned configuration, the second layer 34, having a certain high degree of crystallinity, can be formed under the influence of the first layer 33 (seed layer) having high crystallinity. Consequently, the piezoelectric film 3 having high crystallinity can be provided. In addition, an increase in film stress caused by the difference between thermal expansion coefficients of the piezoelectric film 3 and the lower electrode 2 can be suppressed by forming, on the first layer 33, the second layer 34 including the part formed at the second temperature Te2 lower than the first temperature Te1 as compared with a case where the entire piezoelectric film 3 is formed at a higher temperature. Therefore, it is possible to form the piezoelectric film 3 having high crystallinity while being able to suppress an increase in film stress caused by the difference between the thermal expansion coefficients of the piezoelectric film 3 and the lower electrode 2.

In this embodiment, as described above, the step of forming the second layer 34 includes a step of forming the second layer 34 thicker than the first layer 33. Accordingly, since the thickness Th4 of the second layer 34 can be larger than the thickness Th3 of the first layer 33 formed at the first temperature Te1, it is possible to easily suppress an increase in film stress caused by the difference between thermal expansion coefficients of the piezoelectric film 3 and the lower electrode 2.

In this embodiment, as described above, a thickness Th3 of the first layer 33 is not smaller than 1% and smaller than 50% of the total thickness of the piezoelectric film 3. Accordingly, the thickness Th3 of the first layer 33 set to not smaller than 1% of the total thickness of the piezoelectric film 3 allows the first layer 33 to easily serve as the seed layer. In addition, since the thickness Th3 of the first layer 33 can be prevented from becoming excessively large by setting the thickness Th3 of the first layer 33 to smaller than 50% of the total thickness of the piezoelectric film 3, it is possible to suppress the increase in film stress caused by the difference between the thermal expansion coefficients of the piezoelectric film 3 and the lower electrode 2.

In this embodiment, as described above, the first temperature Te1 is not lower than 560°C and not higher than 700°C; and the second temperature Te2 is not lower than 500°C and lower than 560°C. According to this configuration, the first layer 33 can be easily crystallized and epitaxially grown by setting the first temperature Te1 to not lower than 560°C and not higher than 700°C. In addition, the increase in film stress caused by the difference between thermal expansion coefficients of the piezoelectric film 3 and the lower electrode 2 can be suppressed while the second layer 34 is crystallized by setting the second temperature Te2 to not lower than 500°C and lower than 560°C.

In this embodiment, as described above, the step of forming the second layer 34 includes the step of forming the second layer 34 during continuous temperature change from the first temperature Te1 to the second temperature Te2 after the first layer 33 is formed. Accordingly, since the second layer 34 can easily inherit the crystallinity of the first layer 33, the second layer 34 can be formed with higher crystallinity. Also, dissimilar to a case where the second layer 34 is not formed during the temperature change from the first temperature Te1 to the second temperature Te2, since the second layer 34 can be formed also during the temperature change from the first temperature Te1 to the second temperature Te2, it is possible to improve the productivity.

In this embodiment, as described above, the single-crystalline first region 31 including the first layer 33 and a part of the second layer 34 that inherits the crystal orientation characteristics of the first layer 33, and the polycrystalline second region 32 including the remaining part of the second layer 34 are sequentially formed by sequentially performing the step of forming the first layer 33 and the step of the second layer 34. Accordingly, the piezoelectric film 3 having high crystallinity while suppressing the increase in film stress caused by the difference between the thermal expansion coefficients of the piezoelectric film 3 and the lower electrode 2 can be formed by sequentially forming the first region 31 and the second region 32.

### (Examples)

The following description describes experimental results (an example) of evaluation of the piezoelectric film substrate 100 according to this embodiment with reference to Tables 1 and 2 below.

Table 1 below shows measurement results of film stress caused by the difference in thermal expansion coefficient between the lower electrodes and the piezoelectric films according to a comparative example 1 and the example. In the piezoelectric film substrate according to the example, the piezoelectric film was formed by the manufacturing method according to the aforementioned embodiment forming the first layer at the first temperature at which the first layer crystallizes and epitaxially grows, and the second layer including a part that is formed at the second temperature. In the piezoelectric film substrate according to the comparative example 1, the piezoelectric film was formed entirely as a single crystal at a temperature at which the piezoelectric film crystallizes and epitaxially grows. The thicknesses of the piezoelectric films according to the comparative example 1 and the example were approximately 2 µm.

**[Table 1]**

| | Comp. Ex. 1 (Single-Crystal Film) | Example |
|---|---|---|
| Film Stress | 197 MPa | 148 MPa |

Table 1 shows suppression of the increase in film stress caused by the difference in thermal expansion coefficient between the lower electrode and the piezoelectric film in the example as compared to with the comparative example 1. Accordingly, it has been found that the increase in film stress caused by the difference in thermal expansion coefficient between the lower electrode and the piezoelectric film can be suppressed by forming the piezoelectric film using the manufacturing method according to the aforementioned embodiment as compared with the case of formation of the single-crystal piezoelectric film.

Table 2 below shows measurement results of piezoelectric constant -d₃₁, relative permittivity εᵣ, and performance metric FOM in a comparative example 2 and the example. In the piezoelectric film substrate according to the example, the piezoelectric film was formed by the manufacturing method according to the aforementioned embodiment forming the first layer at the first temperature at which the first layer crystallizes and epitaxially grows, and the second layer including a part that is formed at the second temperature. In the piezoelectric film substrate according to the comparative example 2, the piezoelectric film was entirely formed with polycrystalline at a temperature at which the piezoelectric film crystallizes.

**[Table 2]**

| | Comp. Ex. 2 (Polycrystalline Film) | Example |
|---|---|---|
| Piezoelectric Constant -d₃₁ | 220 pm/V | 239 pm/V |
| Relative Permittivity εᵣ | 900 | 762 |
| Performance Metric FOM | 34 GPa | 48 GPa |

The piezoelectric constant -d₃₁ is an indicator of actuator and sensor properties, with higher values indicating better actuator and sensor properties and lower values indicating poorer actuator and sensor properties. Also, the relative permittivity εᵣ is an indicator of sensor properties, with lower values indicating better actuator and sensor properties and higher values indicating poorer sensor properties. In addition, the relative permittivity εᵣ is an indicator of crystallinity, with lower values indicating better crystallinity and higher values indicating poorer crystallinity. The performance metric FOM is derived from the piezoelectric constant -d₃₁ and the relative permittivity εᵣ, and is proportional to the square of the piezoelectric constant - d₃₁ and inversely proportional to the relative permittivity εᵣ. Higher values of the performance metric FOM indicate better performance, while lower values indicate poorer performance.

Table 2 shows that the piezoelectric constant -d₃₁ is higher in the example than in the comparative example 2. Accordingly, it has been found that the piezoelectric constant -d₃₁ can be increased by forming the piezoelectric film using the manufacturing method according to the aforementioned embodiment, indicating improved actuator and sensor properties, as compared with the case of formation of the polycrystal piezoelectric film.

Also, the relative permittivity εᵣ is lower in the example than in the comparative example 2. Accordingly, it has been found that the relative permittivity εᵣ can be reduced, indicating improved sensor properties, while the crystallinity can be increased by forming the piezoelectric film using the manufacturing method according to the aforementioned embodiment as compared with the case of formation of the polycrystal piezoelectric film.

Also, the performance metric FOM is higher in the example than in the comparative example 2. Accordingly, it has been found that the performance metric FOM can be increased by forming the piezoelectric film using the manufacturing method according to the aforementioned embodiment, indicating improved performance, as compared with the case of formation of the polycrystal piezoelectric film. According to these results, it has been found that the manufacturing method according to the aforementioned embodiment can form the piezoelectric film having high crystallinity while being able to suppress an increase in film stress caused by the difference between the thermal expansion coefficients of the piezoelectric film and the lower electrode. In addition, it has been found that it is possible to form the piezoelectric film having both actuator and sensor properties, and suitable for actuators and sensors.

### (Modified Embodiments)

Note that the embodiment disclosed this time must be considered as illustrative in all points and not restrictive. The scope of the present invention is not shown by the above description of the embodiments but by the scope of claims for patent, and all modifications (modified embodiments) within the meaning and scope equivalent to the scope of claims for patent are further included.

For example, while the example in which the thickness of the first layer is not smaller than 1% and smaller than 50% of the total thickness of the piezoelectric film has been shown in the aforementioned embodiment, the present invention is not limited to this. For example, the thickness of the first layer may be smaller than 1% or not smaller than 50% of the total thickness of the piezoelectric film.

Also, while the example in which the thickness of the second layer is not smaller than 50% of the total thickness of the piezoelectric film has been shown in the aforementioned embodiment, the present invention is not limited to this. For example, the thickness of the second layer may be smaller than 50% of the total piezoelectric film thickness.

Also, while the example in which the first temperature is not lower than 560°C and not higher than 700°C has been shown in the aforementioned embodiment, the present invention is not limited to this. For example, the first temperature may be lower than 560°C, or not lower than 700°C.

Also, while the example in which the second temperature is not lower than 500°C and lower than 560°C has been shown in the aforementioned embodiment, the present invention is not limited to this. For example, the second temperature may be lower than 500°C, or not lower than 560°C.

Also, although the first temperature and the second temperature are described as the wafer surface temperature during deposition in the aforementioned embodiment, the first temperature and the second temperature may differ from an indication temperature indicated as the set temperature of the deposition apparatus. Also, the temperature on the wafer surface is not always uniform over the entire area but may vary from place to place.

Also, while the example in which the second layer is formed during continuous temperature change from the first temperature to the second temperature after the first layer is formed has been shown in the aforementioned embodiment, the present invention is not limited to this. For example, the formation of the piezoelectric film may be interrupted after the first layer is formed, and the second layer may not be formed during the temperature change from the first temperature to the second temperature and the second layer may then be formed after the second temperature is reached.

Also, while the example in which the thickness of the second region is greater than the thickness of the first region has been shown in the aforementioned embodiment, the present invention is not limited to this. For example, the thickness of the first region may be greater than the thickness of the second region. Description of Reference Numerals

- 1;: substrate
- 2;: lower electrode
- 3;: piezoelectric film
- 31;: first region
- 32;: second region
- 33;: first layer
- 34;: second layer
- 100;: piezoelectric film substrate
- Te1;: first temperature
- Te2;: second temperature

## Claims

1. A piezoelectric-film-substrate-manufacturing method comprising:
forming a lower electrode on a substrate; and
forming a piezoelectric film on the lower electrode, wherein
the forming the piezoelectric film includes forming, on the lower electrode, a first layer serving as a seed layer at a first temperature at which the first layer crystallizes and epitaxially grows, and forming, on the first layer, a second layer including a part formed at a second temperature that is lower than the first temperature and at which the part crystallizes.

2. The piezoelectric-film-substrate-manufacturing method according to claim 1, wherein the forming the second layer includes forming the second layer thicker than the first layer.

3. The piezoelectric-film-substrate-manufacturing method according to claim 1, wherein
the first temperature is not lower than 560°C and not higher than 700°C; and
the second temperature is not lower than 500°C and lower than 560°C.

4. The piezoelectric-film-substrate-manufacturing method according to claim 1, wherein the forming the second layer includes forming the second layer during continuous temperature change from the first temperature to the second temperature after the first layer is formed.

5. The piezoelectric-film-substrate-manufacturing method according to claim 2, wherein a thickness of the first layer is not smaller than 1% and smaller than 50% of a total thickness of the piezoelectric film.

6. The piezoelectric-film-substrate-manufacturing method according to claim 1, wherein a single-crystalline first region including the first layer and a part of the second layer that inherits a crystal orientation characteristic of the first layer, and a polycrystalline second region including a remaining part of the second layer are sequentially formed by sequentially performing the forming the first layer and the forming the second layer.

7. A piezoelectric film substrate comprising:
a substrate;
a lower electrode formed on the substrate; and
a piezoelectric film formed on the lower electrode, wherein
the piezoelectric film includes a single-crystalline first region arranged adjacent to the lower electrode and a polycrystalline second region arranged adjacent to the first region.
